(19) Europäisches Patentamt
European Patent Office
Office européen des brevets

(11) **EP 2 840 108 A1**

(12) **EUROPEAN PATENT APPLICATION**

(43) Date of publication:
**25.02.2015 Bulletin 2015/09**

(51) Int Cl.:
**C08J 5/22** (2006.01)  **C08G 61/12** (2006.01)
**C08L 65/00** (2006.01)  **H01B 1/12** (2006.01)

(21) Application number: **14181971.4**

(22) Date of filing: **22.08.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.08.2013   KR 20130100643**

(71) Applicant: **University-Industry Foundation, Yonsei University**
**Seoul 120-743 (KR)**

(72) Inventors:
• **Kim, Jung-Hyun**
**110-819 Seoul (KR)**

• **Kim, Jeonghun**
**153-821 Seoul (KR)**
• **Lee, Seung Hwan**
**152-756 Seoul (KR)**
• **Kim, So Yeon**
**120-823 Seoul (KR)**
• **Yoo, Dohyuk**
**220-951 Gangwon-do (KR)**

(74) Representative: **Eisenführ Speiser Patentanwälte Rechtsanwälte PartGmbB**
**Postfach 10 60 78**
**28060 Bremen (DE)**

(54) **Method for preparing conductive polymer solution and conductive polymer film**

(57)      The present invention relates to a method for preparing a conductive polymer solution and a conductive polymer film, which may increase the doping ratio of a conductive polymer solution and remove ions which have not been removed after the reaction in the conductive polymer solution, unreacted monomers, unreacted oligomers, and polymer electrolytes in excess, through a simple process, and may increase the electrical conductivity of a film prepared by using the conductive polymer through this.

FIG. 1

**Description**

This application claims priority to and the benefit of Korean Patent Application No. 10-2013-0100643 filed on August 23, 2013, the disclosure of which is incorporated hereby by reference in its entirety.

BACKGROUND OF THE INVENTION

1. Field of the Invention

The present invention relates to a method for preparing a conductive polymer solution, and a conductive polymer film.

2. Description of the Related Art

As various home appliances and communication devices including computers are digitalized and high performance thereof is rapidly achieved, there is need for development of a transparent conductive material to be used as an electrode for an electronic device. For example, in order to implement a portable display, an electrode material for a display needs to not only be transparent and exhibit a low resistance, but also have high flexibility capable of responding to mechanical impact, and the short-circuit need not occur and a change in sheet resistance need not be large even though the device is overheated and exposed to a high temperature.

The most frequently used material for a transparent electrode is indium tin oxide (ITO). However, when a transparent electrode is formed of ITO, there is a disadvantage in that excessive costs are needed, and it is difficult to implement a large area. In particular, when an electrode is coated with ITO over a large area, there is a disadvantage in that brightness and light emitting efficiency of a display is decreased due to a large change in sheet resistance. Furthermore, indium, which is a main raw material of ITO, is a limited mineral, and thus is rapidly depleted as the display market is expanded.

In order to overcome the shortcomings of ITO, studies have been conducted on the formation of a transparent electrode using a conductive polymer which is excellent in flexibility and has a simple coating process. However, when a transparent electrode is formed of a conductive polymer, there are problems in that due to ions which are not removed after the reaction, unreacted monomers, unreacted oligomers, and polymer electrolytes in excess, the resistance of a conductive polymer film is increased, and accordingly, electrical conductivity is decreased. For example, in order to lower the resistance of a transparent electrode formed of PEDOT:PSS, studies have been recently conducted on a process of washing a PEDOT:PSS film prepared by using a solvent, such as ethylene glycol, DMSO, and a sulfuric acidic or ionic electrolyte, which is capable of dissolving PSS. However, these methods have a disadvantage in that the process is so complicated that it takes a lot of time to perform the process, and thus there is a problem in that it is limited to actually apply the methods to the industry.

Further, when a transparent electrode is formed of a conductive polymer, there is a problem in that in the conductive polymer after the completion of the reaction, the reaction is completed in a state other than a doping state in which the maximum conductivity may be exhibited, and as a result, low conductivity is exhibited. In order to solve the problem as described above, a method of forming a film using a conductive polymer solution, and then additionally doping the electrode while immersing the electrode in a solution including a dopant has been recently studied, and there is a disadvantage in that the process is complicated, and it takes a lot of time to perform the process. As another method, the doping ratio of a conductive polymer may be increased by adding a dopant to a conductive polymer solution, but when an ionic dopant is put into a PEDOT:PSS solution containing a large amount of an ionic material, there is a disadvantage in that the viscosity of the solution is gradually increased, stability deteriorates, and a phenomenon in which the solution is solidified into a gel occurs. Therefore, it is difficult to industrially use the existing methods.

[Citation List]

[Patent Document]

Korean Patent Application Laid-Open No. 2012-0077112

[Non-Patent Document]

Y. Xia, K. Sun, J. Ouyang, "Solution-Processed Metallic Conducting Polymer Films as Transparent Electrode of Optoelectronic Devices", Advanced Materials, 24 2436-2440, 2012)

SUMMARY OF THE INVENTION

1. Technical Problem

The present invention has been made in an effort to provide a method for preparing a conductive polymer solution and a conductive polymer film having electrical conductivity of 1,500 S/cm or more.

2. Technical Solution

The present invention may provide a method for preparing a conductive polymer solution.

As an example, the present invention may provide a method for preparing a conductive polymer solution, the method including:

preparing a mixture including a conductive polymer, an ion, an ionic polymer electrolyte, and a dopant; and

filtering the mixture by using a filter membrane.

In addition, the present invention may provide a conductive polymer film.

As an example, the present invention may provide

a conductive polymer film having a structure in which a dopant is dispersed in a polymer matrix, and electrical conductivity of 1,500 S/cm or more.

3. Advantageous Effects of Invention

The present invention relates to a method for preparing a conductive polymer solution and a conductive polymer film, and may increase the doping ratio of a conductive polymer solution and remove ions, which have not been removed after the reaction in the conductive polymer solution, unreacted monomers, unreacted oligomers, and polymer electrolytes in excess, through a simple process, and may increase electrical conductivity of a film prepared by using the conductive polymer through this.

BRIEF DESCRIPTION OF THE DRAWINGS

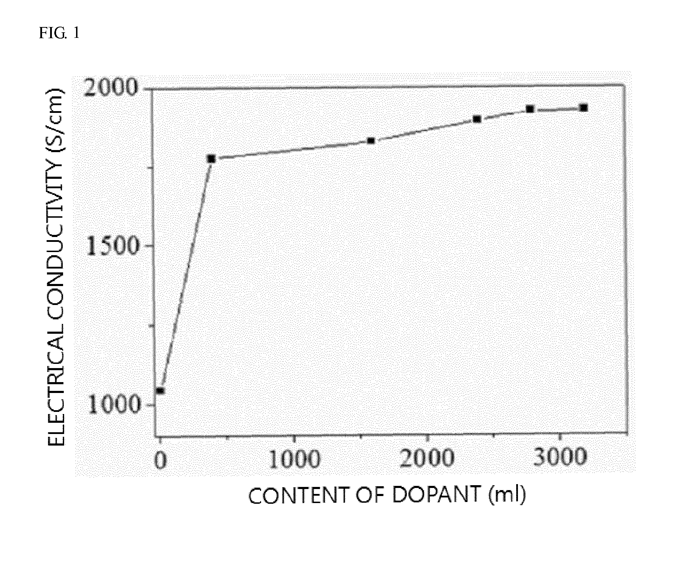

FIG. 1 is a graph illustrating electrical conductivity according to the content of dopant to be mixed with a conductive polymer solution in an exemplary embodiment.

DETAILED DESCRIPTION

The present invention relates to a method for preparing a conductive polymer solution, and a conductive polymer film.

As one example of the method for preparing a conductive polymer solution, a conductive polymer solution may be prepared through preparing a mixture in which a conductive polymer solution including a conductive polymer, an ion, and an ionic polymer electrolyte is mixed with a dopant; and filtering the mixture by using a filter membrane.

For example, the conductive polymer, the ion, the ionic polymer electrolyte, and the dopant may be present in a solvent. The solvent may use distilled water. Specifically, the conductive polymer may be present in a particulate phase in distilled water. Environmental contamination may be reduced by using distilled water instead of an organic solvent.

In the preparing of a mixture in which a conductive polymer solution including a conductive polymer, an ion, and an ionic polymer electrolyte is mixed with a dopant,

the conductive polymer may be one or more selected from the group consisting of, for example, poly(3,4-ethylenedioxythiophene):polystyrene sulfonic acid, polypyrrole:polystyrene sulfonic acid and polythiophene: polystyrene sulfonic acid. Specifically, examples of the conductive polymer include poly(3,4-ethylenedioxythiophene) (PEDOT), polypyrrole (PP), polythiophene (PT), and the like, but are not limited thereto. The conductive polymer may be uncharged or cationic.

The content of poly(3,4-ethylenedioxythiophene):polystyrene sulfonic acid (PEDOT:PSS), polypyrrole:polystyrene sulfonic acid (PP:PSS), and polythiophene:polystyrene sulfonic acid (PT:PSS) may be 0.1 to 10 parts by weight based on 100 parts by weight of the conductive polymer solution. For example, the conductive polymer may be included in an amount of 0.1 to 8 parts by weight, 0.5 to 7 parts by weight, 1 to 5 parts by weight, or 3 to 8 parts by weight. Within a content range of the conductive polymer, a desired product with an appropriate composition may be prepared by appropriately adjusting the content, and thus may be used in various application fields.

For example, the conductive polymer may be cationic. Herein, the "cationic" may relate only to electric charges present on a main chain. Accordingly, the conductive polymer may need anions to compensate for the cations. The anions may be obtained from an ionic polymer electrolyte, and examples of the ionic polymer electrolyte include a monomer anion or a polyanion.

Examples of the monomer anion include $C_1$-$C_{20}$-alkane sulfonic acids, aliphatic perfluorosulfonic acids, aliphatic $C_1$-$C_{20}$-carboxylic acids, aliphatic perfluorocarboxylic acids, aromatic sulfonic acids and cycloalkane sulfonic acids, which are optionally substituted with $C_1$-$C_{20}$-alkyl groups, tetrafluoroborates, hexafluorophosphates, perchlorates, hexafluoroantimonates, hexafluoroarsenates, or hexachloroantimonates. Specific examples thereof include anions such as p-toluenesulfonic acid, methane sulfonic acid, or camphorsulfonic acid.

Examples of the polyanion include an anion of a polymer carboxylic acid (for example, polyacrylic acid, polymethacrylic acid, or polymaleic acid) and anions of a polymer sulfonic acid (for example, polystyrene sulfonic acid and polyvinyl sulfonic acid) and poly(styrene sulfonic acid-co-maleic acid).

Through this, an ion such as a cation and an anion may be present in a solution during the process of forming the bonding structure.

The mixture in which a conductive polymer solution including a conductive polymer, an ion, and an ionic polymer electrolyte is mixed with a dopant may further include a polymer binder. The polymer binder may include, for example, polymer organic binders, for example, polyvinyl alcohol, polyvinyl pyrrolidone, polyvinyl chloride, polyvinyl acetate, polyvinyl butyrate, polyacrylic acid ester, polyacrylamide, polymethacrylic acid ester, polymethacrylamide, polyacrylonitrile, styrene/acrylic acid ester, vinyl acetate/acrylic acid ester, an ethylene/vinyl acetate copolymer, polybutadiene, polyisoprene, polystyrene, polyether, polyester, polycarbonate, polyurethane, polyamide, polyimide, polysulfone, a melamine-formaldehyde resin, an epoxy resin, a silicone resin, and cellulose.

The mixture in which a conductive polymer solution including a conductive polymer, an ion, and an ionic polymer electrolyte is mixed with a dopant may further include an adhesion promoter. Examples of the adhesion promoter include organofunctional silanes, or a hydrolysate thereof. The hydrolysate may include, for example, 3-glycidyloxypropyltrialkoxysilane, 3-aminopropyltriethoxysilane, 3-mercaptopropyltrimethoxysilane, 3- methacryloxypropyltrimethoxysilane, vinyltrimethoxysilane, and octyltriethoxysilane.

Poly(3,4-ethylenedioxythiophene):polystyrene sulfonic acid (PEDOT:PSS), polypyrrole:polystyrene sulfonic acid (PP:PSS), and polythiophene:polystyrene sulfonic acid (PT:PSS), which are the conductive polymer, may be included in a weight ratio of 1:1 to 1:20. For example, the weight ratio may be 1:1.6, 1:2.5, 1:3, 1:5, 1:6, 1:7.5, or 1:10.

The dopant is not particularly limited, but may include an organic compound containing oxygen and nitrogen. For example, the dopant may include one or more selected from the group consisting of an ammonium salt electrolyte, a sodium salt electrolyte, a lithium salt electrolyte, an iron salt electrolyte, a sulfonic acid compound, and sulfuric acid.

The ammonium salt electrolyte may include, for example, one or more of tetra-n-$Bu_4NClO_4$, n-$Bu_4NPF_6$, n-$Bu_4NBF_4$, and n-$Et_4NClO_4$.

The sodium salt electrolyte may include, for example, one or more of $NaPF_6$, $NaBF_4$, and $NaClO_4$.

The lithium salt electrolyte, may include, for example, one or more of $LiClO_4$, $LiPF_6$, $LiBF_4$, $LiN(SO_2CF_3)_2$, $LiN(SO_2C_2F_5)_2$, $LiCF_3SO_3$, $LiC(SO_2CF_3)_3$, $LiPF_4(CF_3)_2$, $LiPF_3(C_2F_5)_3$, $LiPF_3(CF_3)_3$, $LiPF_3(iso-C_3F_7)_3$, $LiPF_5(iso-C_3F_7)$, and a lithium salt electrolyte including a cyclic alkylene group.

For example, the lithium salt including a cyclic alkylene group may include $(CF_2)_2(SO_2)_2NLi$, $(CF_2)_3(SO_2)_2NLi$, and the like.

The iron salt electrolyte may include, for example, ferric (III) p-toluenesulfonic acid.

The sulfonic acid compound may include, for example, one or more of an alkane sulfonic acid having 1 to 20 carbon atoms, a perfluoroalkane sulfonic acid having 1 to 20 carbon atoms, an alkylhexyl carboxylic acid having 1 to 20 carbon atoms, a perfluoroalkane carboxylic acid having 1 to 20 carbon atoms, an aromatic sulfonic acid unsubstituted or substituted with an alkyl group having 1 to 20 carbon atoms, and a cycloalkane sulfonic acid (for example, camphorsulfonic acid).

Specifically, the sulfonic acid compound may include one or more of methanesulfonic acid, ethanesulfonic acid, propanesulfonic acid, butanesulfonic acid, dodecanesulfonic acid, octadecanesulfonic acid, nonadecanesulfonic acid, trifluoromethanesulfonic acid, perfluorobutanesulfonic acid, perfluorooctanesulfonic acid, ethylhexyl carboxylic acid, benzenesulfonic acid, o-toluenesulfonic acid, *p*-toluenesulfonic acid, dodecylbenzenesulfonic acid, dinonylnaphthalene sulfonic acid, dinonyl naphthalene disulfonic acid, and camphorsulfonic acid.

The dopant may be used either alone or in a mixture of two or more thereof.

For example, the dopant may include one or two or more of sulfuric acid and sulfonic acid compounds.

The dopant may be mixed while being dissolved in a solvent.

A solvent used when mixed with the dopant is not particularly limited, as long as the solvent is mixed with water. For example, the solvent may be one or more selected from the group consisting of water, tetrahydrofuran (THF), dimethyl sulfoxide (DMSO), acetonitrile, and an alcohol-based solvent.

In the filtering of the mixture by using a filter membrane, it is possible to remove the unreacted dopant by mixing the conductive polymer solution with the dopant and filtering the unreacted dopant. For example, during the process of mixing the conductive polymer solution with the dopant, the dopant may be doped in the conductive polymer, and in this case, when an unreacted dopant, which is not doped in the conductive polymer, is present in excess, the electrical conductivity may be lowered due to the resistance which unreacted components exhibit. Accordingly, the electrical conductivity may be prevented from being lowered by filtering and removing the unreacted dopant.

The sequence and method of mixing the dopant solution are not particularly limited, but for example, the preparing of a mixture in which a conductive polymer solution including a conductive polymer, an ion, and an ionic polymer electrolyte is mixed with a dopant and the filtering of the mixture by using a filter membrane may be simultaneously performed.

Specifically, in the preparing of a mixture in which a conductive polymer solution including a conductive polymer, an ion, and an ionic polymer electrolyte is mixed with a dopant, the dopant is dissolved in a solvent, and as a result, a dopant solution is mixed, and in the filtering of the mixture by using a filter membrane, the mixture is filtered by using a filtrate, and the input rates of the dopant solution and the filtrate may be equal to each other.

Through this, the process of preparing a conductive polymer solution may be simplified, and the unreacted dopant in excess may be prevented from being produced.

In the method for preparing a conductive polymer solution according to the present invention, the following Equation 1 may be satisfied.

[Equation 1]

$$M1 \leq M < M2$$

In Equation 1,

M denotes a molecular weight critical value of a component which may pass through the filter membrane,
M1 denotes a molecular weight of the ion, and
M2 denotes a molecular weight of a conductive polymer doped with the dopant.

For example, the range of Equation 1 may mean a filter membrane which does not allow the conductive polymer to pass, and may filter a material having the largest molecular weight in the other components. For example, the filter membrane may be a filter membrane which may allow the ion in the solution to pass, and allows an ionic polymer electrolyte, in which the chain is relatively freely removed, to pass, unlike the conductive polymer. As an example, when the molecular weight of the conductive polymer is 1,500,000 Mw and the molecular weight of the ion is 230 Mw, the molecular weight critical value of the component, which may pass through the filter membrane, may be in a range from about 300 to about 1,400,000. Examples of the filter membrane may include filter membranes classified based on the molecular weight, or filter membranes classified based on the pore size, and the like, and the filter membrane is not particularly limited as long as the filter membrane does not allow the conductive polymer to pass.

It is possible to effectively remove the ions, unreacted monomers, unreacted oligomers, and polymer electrolytes in excess, except for the conductive polymer according to the present invention, by using the filter membrane. Through this, the resistance which impurities exhibit may be reduced to increase electrical conductivity of the conductive polymer film.

Examples of the method of filtering a mixture including a conductive polymer, an ion, an ionic polymer electrolyte, and a dopant include vacuum filtration in which filtration is performed under pressure, in addition to micro filtration, ultra filtration, reverse osmosis or hyper filtration, and dialysis, depending on the filtration method. Furthermore, it is possible to use a filtration method including a spiral-wound type, a tubular type, a hollow-fiber type and a plate & frame type, a monolith type, and the like, depending on the module to be used.

In the method for preparing a conductive polymer solution according to the present invention, the following Equation 2 may be satisfied.

$$0.001\% \leq (W1\text{-}W2)/W1 * 100 \leq 70\%$$

In Equation 2,

W1 denotes a content of a component other than the conductive polymer and the solvent, which are contained in the solution before being subjected to the filtering step, and
W2 denotes a content of a component other than the conductive polymer and the solvent, which are contained in the solution after being subjected to the filtering step.

Specifically, in Equation 2, it can be confirmed by the method for preparing a conductive polymer solution according to the present invention that the contents of the ion, the unreacted monomer, the unreacted oligomer, the unreacted dopant in excess, and the polymer electrolyte in excess in the conductive polymer solution according to the present invention have been decreased by 0.001 to 70%, compared to the existing conductive polymer solution which is not subjected to the filtering step. Through this, the resistance of the ion and the unreacted component in the solution may be reduced to increase electrical conductivity.

The filtering of the mixture by using a filter membrane may be performed repeatedly 1 to 20 times, but the number of repetition is not limited thereto. For example, the filtering step may be performed repeatedly 1 to 15 times, 5 to 15 times, or 6 to 12 times. Herein, the one time filtering step may mean that distilled water or a mixed solvent of distilled water and an organic solvent, which corresponds to 50 times the volume of the conductive polymer solution to be treated, is introduced to obtain a filtrate in an amount equivalent to the introduced amount. For example, in the filtering step, the unreacted component may be filtered more effectively by introducing distilled water. By repeatedly performing the step within the range, it is possible to effectively remove the ions which have not been removed after the reaction, the unreacted monomers, the unreacted oligomers, and the polymer electrolytes. Specifically, the polymer electrolyte may be effectively removed. Additionally, the conductive polymer according to the present invention may be prevented from being filtered. When the range exceeds, the conductive polymer may be filtered or bonding particulates may be affected by the excessive filtering step, thereby inhibiting electrical conductivity. In this case, as a solvent, distilled water is used, but the solvent is not limited thereto, and a mixed solvent of distilled water and an organic solvent may be used.

The present invention may include a conductive polymer film. As an example, the present invention may include a conductive polymer film having a structure in which a dopant is doped in a conductive polymer matrix, and electrical conductivity of 1,500 S/cm or more.

Specifically, the conductive polymer film may have a structure in which a dopant is dispersed in a polymer matrix formed of a conductive polymer.

For example, the conductive polymer film may have electrical conductivity in a range of 1,200 to 1,700 S/cm, 1,400 to 1,700 S/cm, or 1,700 to 1,900 S/cm. The conductive polymer film according to the present invention may mean that electrical conductivity within the range is a low sheet resistance. Through this, a high performance may be implemented when the conductive polymer film is applied to an electronic device.

Since the explanation for the dopant and the conductive polymer is the same as or equivalent to the explanation described above, the explanation thereof will be omitted.

Hereinafter, the present invention will be described in more detail through the Examples according to the present invention, and the like, but the scope of the present invention is not limited by the following Examples.

**Example 1**

12.53 g (Mw: 75,000) of polystyrene sulfonic acid (PSS) was dissolved in 1,400 g of distilled water, and then the resulting solution was stirred for 1 hour. Then, 0.2 g of iron sulfate was added thereto and stirred until being dissolved. During stirring, nitrogen was introduced thereto for 1 hour, and flowed into the solution. When the iron sulfate was completely dissolved, the temperature of the solution was decreased to 17°C, 5.014 g of a 3,4-ethylenedioxythiophene (EDOT) monomer was added thereto, and 30 g of an aqueous solution in which 11.9 g of sodium persulfate was dissolved was introduced thereto. Then, a polymerization reaction was performed for 24 hours while the system was not in contact with air and nitrogen was introduced thereto several times, and then a conductive polymer solution was prepared by putting 500 ml of a mixed ion exchange resin in which a cation exchange resin and an anion exchange resin were mixed in a ratio of 1:1 thereto to remove unnecessary ions. Then, the ion exchange resin was removed, 100 ml of a 0.05 wt% sulfuric acid aqueous solution as a dopant was mixed in the conductive polymer solution, and then the resulting mixture was stirred. Then, the solution was filtered by an ultra filtration method using a membrane film having 100 nm pores, and in this case, filtration was performed by continuously introducing distilled water thereto. Through this, components other than PEDOT:PSS polymer particles were removed. As a result, it could be confirmed that the solution filtered through the filter membrane was a solution including PSS, which is an acidic material, as an acidic solution with a pH of 4 or less. The filtrate was prepared as a solution with a concentration as low as 1.3%, then a DMSO solution, which is 5% compared to the weight of the solution, was added thereto and the resulting mixture was sufficiently mixed, and the resulting solution was coated using a bar coating and dried at 150°C for 30 minutes, thereby preparing a conductive polymer film.

**Example 2**

A conductive polymer film was prepared in the same manner as in Example 1, except that the dopant was mixed by varying the content thereof to 500 ml.

**Example 3**

A conductive polymer film was prepared in the same manner as in Example 1, except that the dopant was mixed by varying the content thereof to 3,000 ml.

**Example 4**

A conductive polymer film was prepared in the same manner as in Example 1, except that the dopant was mixed by varying the content thereof at 3,000 ml, and the introduction of the dopant and the filtration using distilled water were simultaneously performed.

**Example 5**

A conductive polymer film was prepared in the same manner as in Example 1, except that 3,000 ml of p-toluenesulfonic acid was mixed as a dopant.

**Example 6**

A conductive polymer film was prepared in the same manner as in Example 1, except that 3,000 ml of p-toluenesulfonic acid was mixed as a dopant, and the introduction of the dopant and the filtration using distilled water were simultaneously performed.

**Example 7**

A conductive polymer film was prepared in the same manner as in Example 1, except that a CLEVIOS PH1000 solution manufactured by Heraeus Inc., was used as a conductive polymer solution.

**Example 8**

A conductive polymer film was prepared in the same manner as in Example 1, except that a CLEVIOS PH1000 solution manufactured by Heraeus Inc., was used as a conductive polymer solution, and the dopant was mixed by varying the content thereof at 500 ml.

**Example 9**

A conductive polymer film was prepared in the same manner as in Example 1, except that a CLEVIOS PH1000 solution manufactured by Heraeus Inc., was used as a conductive polymer solution, and the dopant was mixed by varying the content thereof at 3,000 ml.

**Example 10**

A conductive polymer film was prepared in the same manner as in Example 1, except that a CLEVIOS PH1000 solution manufactured by Heraeus Inc., was used as a conductive polymer solution, the dopant was mixed by varying the content thereof at 3,000 ml, and the introduction of the dopant and the filtration using distilled water were simultaneously performed.

**Example 11**

A conductive polymer film was prepared in the same manner as in Example 1, except that a CLEVIOS PH1000 solution manufactured by Heraeus Inc., was used as a conductive polymer solution, and 3,000 ml of p-toluenesulfonic acid was mixed as a dopant.

**Example 12**

A conductive polymer film was prepared in the same manner as in Example 1, except that a CLEVIOS PH1000 solution manufactured by Heraeus Inc., was used as a conductive polymer solution, 3,000 ml of p-toluenesulfonic acid was mixed as a dopant, and the introduction of the dopant and the filtration using distilled water were simultaneously performed.

**Comparative Example 1**

A conductive polymer film was prepared in the same manner as in Example 1, except that the conductive polymer film was not subjected to the mixing of the dopant and filtering through the filter membrane.

**Comparative Example 2**

A conductive polymer film was prepared in the same manner as in Example 1, except that the dopant was not mixed.

**Comparative Example 3**

A conductive polymer film was prepared in the same manner as in Example 1, except that a CLEVIOS PH1000 solution manufactured by Heraeus Inc., was used as a conductive polymer solution, and the conductive polymer film was not subjected to the mixing of the dopant and filtering through the filter membrane.

**Comparative Example 4**

A conductive polymer film was prepared in the same manner as in Example 1, except that a CLEVIOS PH1000 solution manufactured by Heraeus Inc., was used as a conductive polymer solution, and the polymer film was not subjected to the mixing of the dopant.

**Experimental Example**

An electrical conductivity measurement experiment was performed on the conductive polymer films prepared in Examples 1 to 12 and Comparative Examples 1 to 4. The results are shown in the following Table 1.

[Table 1]

|  | Electrical conductivity (S/cm) |
|---|---|
| Example 1 | 670 |
| Example 2 | 879 |
| Example 3 | 1,340 |
| Example 4 | 1,450 |
| Example 5 | 1,568 |
| Example 6 | 1,587 |
| Example 7 | 1,514 |
| Example 8 | 1,790 |
| Example 9 | 1,927 |
| Example 10 | 1,932 |
| Example 11 | 1,934 |
| Example 12 | 1,945 |
| Comparative Example 1 | 435 |
| Comparative Example 2 | 560 |
| Comparative Example 3 | 780 |
| Comparative Example 4 | 1,120 |

Referring to Table 1, it could be confirmed that the conductive polymer films prepared in Examples 1 to 12 according to the present invention had higher values than those of the conductive polymer films prepared in the Comparative Examples in which the conductive polymer films were not subjected to the mixing of the dopant and the filtering through the filter membrane under the same conditions.

**Claims**

1. A method for preparing a conductive polymer solution, the method comprising:

   preparing a mixture in which a conductive polymer solution comprising a conductive polymer, an ion, and an ionic polymer electrolyte is mixed with a dopant; and
   filtering the mixture by using a filter membrane.

2. The method of claim 1, wherein a content of the dopant is 0.0001 to 30 parts by weight based on 100 parts by weight of the conductive polymer solution.

3. The method of claim 1, wherein in the preparing of the mixture in which the solution and the dopant are mixed, the dopant is mixed while being dissolved in a solvent.

4. The method of claim 3, wherein the solvent is one or more selected from the group consisting of water, tetrahydrofuran (THF), dimethyl sulfoxide (DMSO), acetonitrile, and an alcohol-based solvent.

5. The method of claim 1, wherein in the filtering of the mixture by using a filter membrane, the unreacted dopant is removed by mixing the conductive polymer solution with the dopant and filtering the unreacted dopant.

6. The method of claim 1, wherein the preparing of a mixture in which a conductive polymer solution comprising a conductive polymer, an ion, and an ionic polymer electrolyte is mixed with a dopant; and the filtering of the mixture by using a filter membrane are simultaneously performed.

7. The method of claim 6, wherein

   in the preparing of a mixture in which a conductive polymer solution comprising a conductive polymer, an ion, and an ionic polymer electrolyte is mixed with a dopant,

   the dopant is dissolved in a solvent, and as a result, a dopant solution is mixed, and

   in the filtering of the mixture by using a filter membrane,

   the mixture is filtered by using a filtrate, and
   the input rates of the dopant solution and the filtrate are equal to each other.

8. The method of claim 1, wherein the following Equation 1 is satisfied:

$$[\text{Equation 1}]$$

$$M1 < M < M2$$

in Equation 1,

M denotes a molecular weight critical value of a component which is capable of passing through the filter membrane,
M1 denotes a molecular weight of the ion, and
M2 denotes a molecular weight of a conductive polymer doped with the dopant.

9. The method of claim 1, wherein the following Equation 2 is satisfied:

$$[\text{Equation 2}]$$

$$0.001\% \leq (W1-W2)/W1 * 100 \leq 70\%$$

in Equation 2,

W1 denotes a content of a component other than the conductive polymer and the solvent, which are contained in the solution before being subjected to the filtering step, and

W2 denotes a content of a component other than the conductive polymer and the solvent, which are contained in the solution after being subjected to the filtering step.

10. A conductive polymer film having a structure in which a dopant is doped in a conductive polymer matrix, and electrical conductivity of 1,200 S/cm or more.

11. The conductive polymer film of claim 10, wherein the conductive polymer is one more selected from the group consisting of poly(3,4-ethylenedioxythiophene):polystyrene sulfonic acid, polypyrrole:polystyrene sulfonic acid, polythiophene:polystyrene sulfonic acid, and polyaniline:polystyrene sulfonic acid.

12. The conductive polymer film of claim 10, wherein the dopant is one or more selected from the group consisting of an ammonium salt electrolyte, a sodium salt electrolyte, a lithium salt electrolyte, an iron salt electrolyte, a sulfonic acid compound, and sulfuric acid.

FIG. 1

**Europäisches Patentamt**
**European Patent Office**
**Office européen des brevets**

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YIJIE XIA ET AL: "Solution-Processed Metallic Conducting Polymer Films as Transparent Electrode of Optoelectronic Devices", ADVANCED MATERIALS, vol. 24, no. 18, 8 May 2012 (2012-05-08), pages 2436-2440, XP055149680, ISSN: 0935-9648, DOI: 10.1002/adma.201104795 * figures 1,2 * | 10-12 | INV. C08J5/22 C08G61/12 C08L65/00 H01B1/12 |
| X | EP 1 988 128 A1 (SHINETSU POLYMER CO [JP]) 5 November 2008 (2008-11-05) * paragraph [0128]; examples 1,7,17 * | 1-12 | |
| X | US 2006/076541 A1 (YOSHIDA KAZUYOSHI [JP] ET AL) 13 April 2006 (2006-04-13) * paragraphs [0177], [0181], [0261] - [0305] * | 1-12 | |
| X | EP 1 947 655 A1 (SHINETSU POLYMER CO [JP]) 23 July 2008 (2008-07-23) * paragraph [0085]; examples 1,2 * | 1-12 | TECHNICAL FIELDS SEARCHED (IPC) C08J C08G |
| X | US 2006/047030 A1 (YOSHIDA KAZUYOSHI [JP] ET AL) 2 March 2006 (2006-03-02) * paragraphs [0093] - [0105], [0321], [0332], [0378] - [0380], [0392] - [0394]; examples 1,35-42 * | 1-12 | C08L H01B |

The present search report has been drawn up for all claims

| Place of search | Date of completion of the search | Examiner |
|---|---|---|
| Munich | 29 October 2014 | Meiners, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 .........................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**                     EP 14 18 1971

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2014

| Patent document cited in search report | | Publication date | Patent family member(s) | | Publication date |
|---|---|---|---|---|---|
| EP 1988128 | A1 | 05-11-2008 | CN | 102831947 A | 19-12-2012 |
| | | | EP | 1988128 A1 | 05-11-2008 |
| | | | EP | 2147953 A2 | 27-01-2010 |
| | | | JP | 4987738 B2 | 25-07-2012 |
| | | | KR | 20080092478 A | 15-10-2008 |
| | | | TW | 201127918 A | 16-08-2011 |
| | | | US | 2009021894 A1 | 22-01-2009 |
| | | | US | 2013294013 A1 | 07-11-2013 |
| | | | WO | 2007091656 A1 | 16-08-2007 |
| US 2006076541 | A1 | 13-04-2006 | CN | 101035860 A | 12-09-2007 |
| | | | EP | 1798259 A1 | 20-06-2007 |
| | | | TW | I325007 B | 21-05-2010 |
| | | | US | 2006076541 A1 | 13-04-2006 |
| | | | US | 2011033651 A1 | 10-02-2011 |
| | | | US | 2011038095 A1 | 17-02-2011 |
| | | | WO | 2006041032 A1 | 20-04-2006 |
| EP 1947655 | A1 | 23-07-2008 | CN | 102708945 A | 03-10-2012 |
| | | | EP | 1947655 A1 | 23-07-2008 |
| | | | EP | 2109117 A1 | 14-10-2009 |
| | | | KR | 20080065623 A | 14-07-2008 |
| | | | TW | I395230 B | 01-05-2013 |
| | | | US | 2009244027 A1 | 01-10-2009 |
| | | | WO | 2007037292 A1 | 05-04-2007 |
| US 2006047030 | A1 | 02-03-2006 | CN | 101040002 A | 19-09-2007 |
| | | | TW | I303832 B | 01-12-2008 |
| | | | US | 2006047030 A1 | 02-03-2006 |
| | | | US | 2010097743 A1 | 22-04-2010 |
| | | | US | 2010098841 A1 | 22-04-2010 |
| | | | US | 2012057269 A1 | 08-03-2012 |
| | | | WO | 2006025262 A1 | 09-03-2006 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020130100643
- KR 20120077112

**Non-patent literature cited in the description**

- **Y. XIA ; K. SUN ; J. OUYANG.** Solution-Processed Metallic Conducting Polymer Films as Transparent Electrode of Optoelectronic Devices. *Advanced Materials,* 2012, vol. 24, 2436-2440